Europäisches Patentamt

European Patent Office

Office européen des brevets

(11) Numéro de publication: **0 356 346 B1**

# FASCICULE DE BREVET EUROPEEN

(45) Date de publication de fascicule du brevet: **15.12.93**  (51) Int. Cl.5: **H01L 27/10**, G11C 17/00

(21) Numéro de dépôt: **89420286.0**

(22) Date de dépôt: **31.07.89**

(54) **Mémoire de type EPROM à haute densité d'intégration.**

(30) Priorité: **11.08.88 FR 8810962**

(43) Date de publication de la demande:
**28.02.90 Bulletin 90/09**

(45) Mention de la délivrance du brevet:
**15.12.93 Bulletin 93/50**

(84) Etats contractants désignés:
**DE FR GB IT NL**

(56) Documents cités:
**EP-A- 0 182 198**
**GB-A- 2 073 484**
**US-A- 4 258 466**
**US-A- 4 373 248**

(73) Titulaire: **SGS-THOMSON MICROELECTRO-NICS S.A.**
**7, Avenue Gallièni**
**F-94250 Gentilly(FR)**

(72) Inventeur: **Bergemont, Albert**
**25, Chemin Pré Morin**
**F-38700 Corenc(FR)**

(74) Mandataire: **de Beaumont, Michel**
**1bis, rue Champollion**
**F-38000 Grenoble (FR)**

**Description**

La présente invention concerne les mémoires à semiconducteur, et plus particulièrement les mémoires non-volatiles électriquement programmables, plus couramment appelées mémoires EPROM ; la fabrication des mémoires à grille flottante est plus précisément concernée.

Pour obtenir des mémoires de grande capacité de stockage, par exemple des mémoires capables de stocker jusqu'à 16 mégabits, on doit réduire le plus possible la dimension de chacune des cellules constituant la mémoire.

Mais on est évidemment limité par des considérations physiques, et notamment par la finesse des motifs que permettent les étapes de photolithographie ; on est limité aussi par les paramètres électriques parasites qui sont dus au processus de fabrication et qui perturbent le fonctionnement de la mémoire.

Sauf quelques exceptions qui n'ont pas encore eu de succès industriel, toutes les approches essayées pour conduire à des mémoires de grande capacité telles que celles décrites dans US-A-4 258 466 correspondent à une technologie dont les points essentiels sont les suivants :

- le point-mémoire individuel est constitué d'un transistor ayant une grille flottante réalisée par un premier niveau de silicium polycristallin et une grille de commande réalisée par un deuxième niveau de silicium polycristallin ;
- les sources des transistors sont connectées à un bus à potentiel bas Vss ;
- la ligne de mot pour désigner une ligne de cellules est constituée du deuxième niveau de silicium polycristallin ;
- la ligne de bit pour lire l'état d'une cellule est constituée d'une ligne de métal (aluminium) croisant les lignes de mot et contactant de place en place le drain des transistors ;
- pour réduire la taille du point-mémoire, on prévoit qu'un seul point de contact est prévu pour deux drains adjacents de deux transistors d'une même colonne, ce contact assurant la connexion à la ligne de bit ; de même, on prévoit un seul contact entre les sources de deux transistors adjacents et le bus à Vss ;
- les transistors sont séparés les uns des autres par de l'oxyde de silicium épais (comparativement à l'oxyde de grille des transistors), et les lignes de bit et les lignes de mot passent au-dessus de cet oxyde épais ;
- enfin, l'écriture d'une information dans une cellule de la mémoire se fait de la manière suivante : les sources de tous les transistors de la mémoire sont à un potentiel bas Vss (par exemple zéro volt) ; la ligne de mot connectée à la grille de commande de la cellule à programmer est portée à un potentiel de programmation Vpp (par exemple 15 volts), tandis que toutes les autres lignes de mot sont au potentiel bas Vss ; la ligne de bit correspondant au point à programmer est portée à un potentiel haut Vcc (par exemple 10 volts), tandis que les lignes de bit des points qui ne doivent pas être programmés sont maintenues au potentiel bas Vss.

Avec cette architecture de mémoire et le mode de programmation associé, il est impératif que le drain d'un transistor soit électriquement isolé, par de l'oxyde épais, du drain des transistors adjacents de la même ligne de mot, faute de quoi on ne pourrait programmer un point-mémoire particulier sans programmer ou déprogrammer en même temps les autres.

Mais l'oxyde épais qui isole deux points adjacents occupe beaucoup de place, surtout lorsqu'il est réalisé par la technique dite d'oxydation localisée.

On a essayé de remplacer l'oxydation localisée par une isolation par tranchées remplies d'oxyde, pour réduire l'encombrement global de la cellule, mais cette technologie n'est pas industriellement au point.

On a également proposé (demande de brevet français 86/12940) des structures où les zones d'oxyde épais et les contacts multiples vers les drains ou sources sont supprimés. Ces structures permettent effectivement une miniaturisation du réseau mémoire mais au prix d'une complexification du système d'adressage et donc d'une augmentation de la surface occupée par celui-ci.

Pour réduire l'encombrement des cellules et ainsi augmenter la capacité de stockage de la mémoire, la présente invention propose une nouvelle architecture de mémoire qui permet de ne prévoir une telle zone d'oxyde épais que tous les deux transistors connectés à une même ligne de mot. De plus, la nouvelle architecture proposée permet d'éviter la présence de contacts sur les lignes de bit entre les cellules.

Selon l'invention, la mémoire comprend des transistors MOS à grille flottante et est composée d'un réseau de lignes de mot s'étendant suivant une première direction, dite de rangées, reliant des grilles de commande des transistors, et de lignes de bit s'étendant suivant une deuxième direction, dite de colonnes, reliant des drains des transistors, les lignes de mot servant à désigner une rangée de transistors déterminée et les lignes de bit permettant de transmettre une information sur l'état logique des transistors qui leur sont connectés. Une ligne à potentiel constant, qui s'étend selon une colonne, relie des sources desdits transistors, est constituée par une diffusion d'un premier type de conductivité, et est intercalée une fois sur deux entre deux lignes de bit, toutes les lignes à potentiel constant étant au même potentiel. La région de drain du premier type de conductivité de chaque transistor se prolonge suivant une colonne pour former une ligne de bit. Une zone d'isolement s'étendant selon une colonne est disposée du côté de chaque ligne de bit opposé à une ligne à potentiel constant. Une zone conductrice et flottante recouvre chaque zone d'isolement, cette zone étant composée du même matériau que celui constituant les grilles flottantes des transistors.

Selon un mode de réalisation de la présente invention, les transistors d'un groupe appartenant à deux rangées adjacentes et deux colonnes de part et d'autre d'une même ligne à potentiel constant sont agencés de la manière suivante :

- chaque transistor comporte une grille flottante essentiellement constituée par un rectangle conducteur situé au dessus d'une zone d'un second type de conductivité constituant le canal du transistor ;
- les canaux de deux transistors adjacents d'une même colonne sont séparés par une région de même type de conductivité que les canaux ;
- les canaux de deux transistors d'une même rangée, les deux transistors étant situés de part et d'autre d'une même ligne à potentiel constant, sont adjacents à une même région de type de conductivité opposé qui les sépare et qui sert de source aux deux transistors ; les canaux des deux transistors sont, chacun à leur extrémité opposée à celle adjacente à la région servant de source, adjacents à une région de type de conductivité opposé qui sert de drain à chacun des deux transistors.

Selon un mode de réalisation de la présente invention, la zone recouvrant la zone d'isolement, ainsi que les grilles flottantes, sont constituées de silicium polycristallin.

Selon un mode de réalisation de la présente invention, la zone recouvrant la zone d'isolement déborde, suivant la direction parallèle aux lignes de mot, de chaque côté de la zone d'isolement d'une longueur choisie (1).

Selon un mode de réalisation de la présente invention, les zones recouvrant les zones d'isolement et les grilles flottantes sont disposées à espacement constant suivant la direction des rangées.

Selon un mode de réalisation de la présente invention, dans les transistors des cellules, une couche de dioxyde de silicium d'une épaisseur inférieure à 20 nm sépare le canal et la grille flottante, et la région servant de source peut être constituée d'une partie à haut dopage située dans un caisson du même type de conductivité à faible dopage, d'où il résulte que des électrons peuvent transiter à travers la couche de dioxyde de silicium par effet tunnel de la grille flottante à la partie de la source à haut dopage sous l'application d'une tension adaptée à la source, la présence du caisson à faible dopage permettant d'augmenter la tension de claquage entre la source et le substrat, ce qui donne à la mémoire la capacité d'être effacée électriquement par application d'une tension adaptée aux sources des transistors.

Ces objets, caractéristiques et avantages ainsi que d'autres de la présente invention seront exposés plus en détail dans la description suivante d'un mode de réalisation particulier faite en relation avec les figures jointes parmi lesquelles :

les figures 1A et 1B représentent une cellule élémentaire de mémoire classique, la figure 1A étant une représentation sous forme de schéma électrique et la figure 1B étant une vue en coupe schématique de la cellule élémentaire ;

la figure 2 représente une vue de dessus de l'implantation de six points-mémoire adjacents sur une tranche de silicium selon l'art antérieur ;

la figure 3 représente une vue en coupe suivant l'axe YY' de la figure 2 ;

la figure 4 représente une vue en coupe suivant l'axe ZZ' de la figure 2 ;

la figure 5 représente une vue de dessus de l'implantation de quatre points-mémoire adjacents sur une tranche de silicium selon la présente invention ;

la figure 6 représente une vue en coupe suivant l'axe YY' de la figure 5 ;

la figure 7 représente une vue en coupe suivant l'axe ZZ' de la figure 5 ;

la figure 8 représente un schéma des capacités existant autour d'une zone d'isolement ; et

la figure 9 représente, selon une coupe analogue à celle de la figure 6, une variante de réalisation de l'invention.

De façon générale, comme cela est classique dans la représentation des circuits intégrés, on notera que les diverses figures ne sont pas représentées à l'échelle ni d'une figure à l'autre, ni à l'intérieur d'une même figure, et notamment que les épaisseurs des couches sont dessinées arbitrairement dans le but de faciliter la lecture des figures.

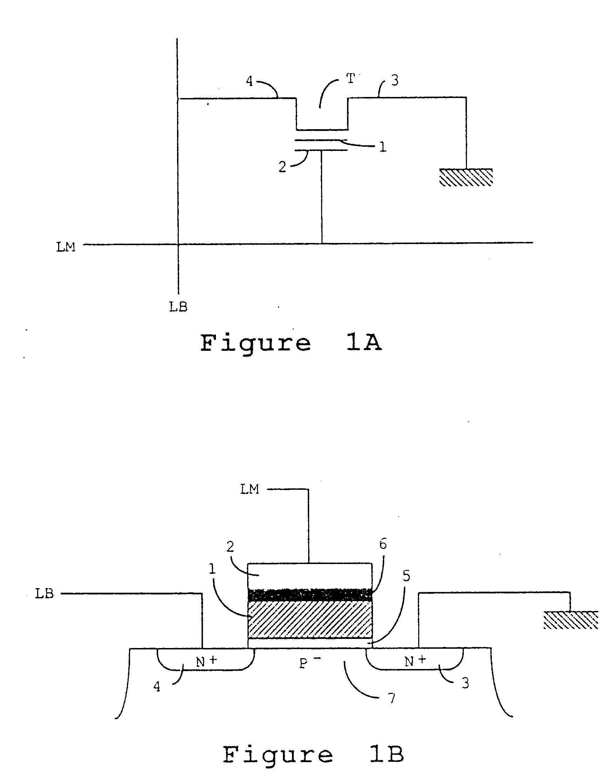

La figure 1A représente un transistor T d'un point-mémoire à grille flottante. Ce transistor possède une grille flottante 1 et une grille de commande 2, ainsi que deux régions semiconductrices d'un premier type de conductivité (source 3 et drain 4) séparées par une région de canal d'un type de conductivité opposé recouverte par la grille flottante 1 et la grille de commande 2.

La grille de commande 2 est reliée à une ligne de mot LM. Le drain 4 est relié à une ligne de bit LB.

Pour programmer, ou écrire, un tel point-mémoire, on charge sa grille flottante 1 par injection de porteurs chauds, en appliquant à la grille de commande 2, pendant que le transistor conduit un courant entre ses régions de source 3, mises à la masse, et de drain 4, un potentiel suffisamment élevé pour que les porteurs de charge (électrons) soient attirés et piégés dans la grille flottante. Cette opération d'écriture a pour effet d'augmenter le seuil de conduction du transistor qui, une fois programmé, ne conduira le courant que pour des valeurs de potentiel appliqué sur la grille de commande plus élevées qu'en l'absence de programmation.

Lors de la lecture de l'information contenue dans un point-mémoire, on applique à la grille de commande du transistor de ce point-mémoire une tension à la fois supérieure à la tension de seuil de déclenchement de conduction à l'état non-programmé et inférieure à la tension de seuil de déclenchement de conduction à l'état programmé. Si le transistor conduit le courant quand une différence de potentiel adaptée est appliquée entre la source et le drain, le point-mémoire est à l'état non-programmé. Si le transistor ne conduit pas le courant, le point-mémoire est à l'état programmé.

Le potentiel appliqué à la grille de commande lorsqu'on programme le point-mémoire, ou potentiel de programmation Vpp, est par exemple de 15 volts. Le potentiel de drain Vcc est alors par exemple de 10 volts, et le potentiel de source Vss est par exemple zéro volt, ou la masse.

Le potentiel appliqué à la grille de commande lors de la lecture du point-mémoire est par exemple de 5 volts. Le potentiel de drain Vcc est alors par exemple de 1,5 volts, et le potentiel de source Vss est par exemple zéro volt, ou la masse.

Sur la figure 1B, qui représente une vue en coupe d'un point-mémoire implanté sur une tranche de silicium, on retrouve la grille flottante 1 et la grille de commande 2 du transistor. On voit également la source 3 et le drain 4, qui sont deux régions semiconductrices d'un premier type de conductivité, par exemple $N^+$, séparées par une région de canal 7 d'un type de conductivité opposé, par exemple $P^-$.

La grille flottante 1 du transistor est réalisée par un premier niveau de silicium polycristallin (poly 1). Elle est séparée du substrat par une couche de dioxyde de silicium 5, également appelée couche d'oxyde de grille.

Au-dessus de la grille flottante 1, on trouve une couche de dioxyde de silicium 6. Cette couche est située entre la grille flottante 1 et la grille de commande 2, cette dernière étant réalisée par un deuxième niveau de silicium polycristallin (poly 2). La couche de dioxyde de silicium 6 porte ainsi également le nom de couche d'oxyde interpoly.

Dans la mémoire, la grille de commande 2 du transistor est reliée à une ligne de mot LM. La source 3 est reliée à la masse, et le drain 4 à une ligne de bit LB.

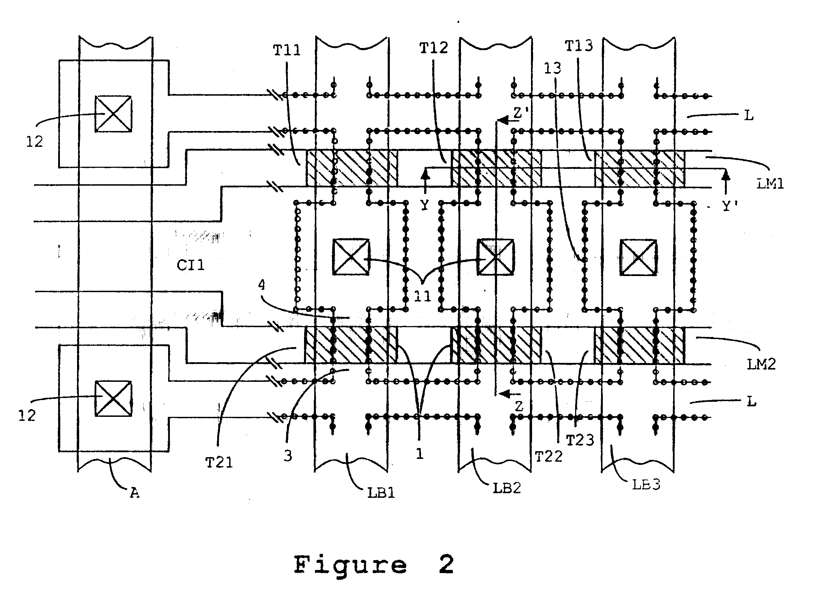

La figure 2 représente en vue de dessus un mode d'implantation classique de six points-mémoire adjacents sur une tranche de silicium.

On désigne par Tij les différents transistors à grille flottante constituant le réseau de points-mémoire, où i est un indice de rangée et j un indice de colonne.

Ainsi, les transistors T11 à T13 sont ceux de la première rangée, les transistors T21 à T23 sont ceux de la deuxième rangée.

De même, les transistors T11 et T21 sont ceux de la première colonne, les transistors T12 et T22 sont ceux de la deuxième colonne et enfin les transistors T13 et T23 sont ceux de la troisième colonne.

Les grilles de commande des transistors d'une même rangée sont toutes reliées à une même ligne de mot, LM1 et LM2 pour les rangées 1 et 2, respectivement.

Les drains des transistors d'une même colonne sont tous reliés à une même ligne de bit, LB1 à LB3 pour les colonnes 1 à 3, respectivement.

Les lignes de mot sont des conducteurs (en pratique en silicium polycristallin) s'étendant selon une direction horizontale (direction des rangées). Les lignes de bit sont des conducteurs s'étendant dans une direction verticale (direction des colonnes).

Les lignes de bit passent au-dessus des transistors Tij formant les points-mémoire.

Elles sont reliées aux drains 4 des transistors par des contacts 11. Les grilles flottantes 1 des transistors sont situées entre les drains 4 et les sources 3.

Les sources des transistors d'une même rangée sont toutes reliées à une ligne commune L. Un couple de deux rangées de transistors, séparé d'un couple adjacent par une rangée de contacts 11, partage une ligne commune L unique, qui est placée entre les deux rangées.

Toutes les lignes communes L sont reliées par un contact 12 à une ligne conductrice A qui, étant elle-même au potentiel de source Vss, permet d'appliquer aux sources des transistors la tension Vss.

Une zone d'isolement 13 est située entre chaque ligne commune L et entre chaque colonne de transistors. En pratique, la zone d'isolement est réalisée en oxyde de silicium épais (comparativement à l'oxyde de grille).

La grille flottante 1 des transistors déborde sur la zone d'isolement.

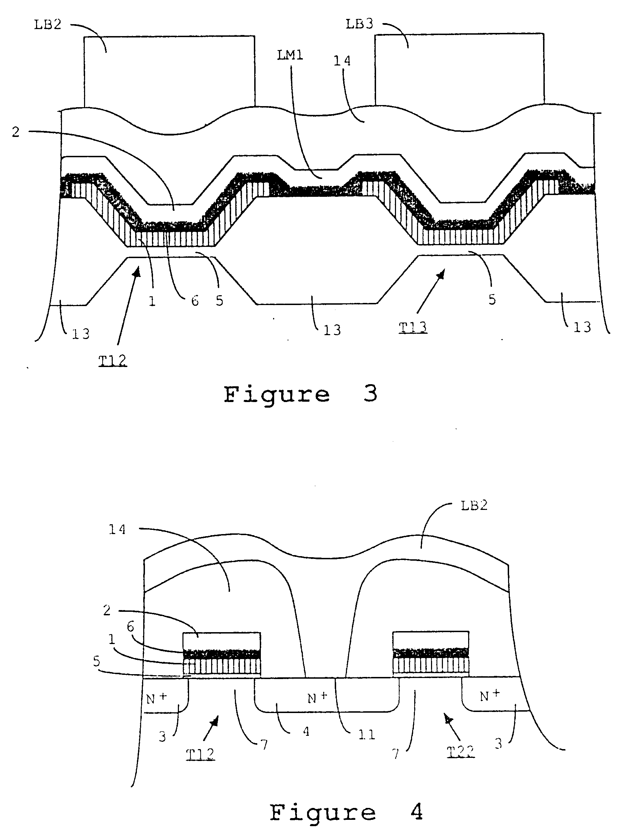

Deux transistors, par exemple les transistors T12 et T13, sont représentés sur la figure 3 qui est une coupe suivant l'axe YY' de la figure 2.

Ils sont séparés par une zone d'isolement 13. Sous la grille flottante 1 se trouve la couche d'oxyde de grille 5. La grille flottante 1 a des dimensions plus grandes suivant cette direction de coupe que la couche d'oxyde de grille 5, et elle déborde sur les zones d'isolement. On observe au-dessus de la grille flottante la couche d'oxyde interpoly 6. La ligne de mot LM1 court le long de la rangée de transistors et fait office de grille de commande 2 à l'emplacement des transistors.

La ligne de mot LM1 est recouverte par une couche isolante 14. Cette couche isolante 14 est par exemple réalisée en oxyde de silicium dopé au bore et au phosphore (BPSG) qui permet d'obtenir un bon fluage à faibles températures (d'environ 850 à 950 ° C).

Les lignes de bit LB2 et LB3 sont situées sur la couche isolante 14, au-dessus des transistors T12 et T13 respectivement.

On voit sur la figure 4, qui représente une vue en coupe suivant l'axe ZZ' de la figure 2, les deux transistors T12 et T22.

Comme cela a été montré sur la figure 1B, chaque transistor comprend une région de source 3 et une région de drain 4 séparées par une région de canal 7, ainsi que la superposition des couches formant l'oxyde de grille 5, la grille flottante 1, l'oxyde interpoly 6 et la grille de commande 2.

Les grilles de commande des transistors sont recouvertes par la couche isolante 14. La ligne de bit LB2 est reliée aux drains des deux transistors par le contact 11.

L'architecture classique, telle qu'on vient de la décrire, présente cependant des éléments qui limitent la réduction des dimensions. D'une part, on trouve une série de contacts entre lignes de bit et régions de drains toutes les deux rangées de transistors. D'autre part, on voit sur la figure 2 qu'une zone d'isolement 13, réalisée en oxyde de silicium épais, est située entre chaque paire de lignes communes 2 et entre chaque paire de colonnes de transistors.

Egalement, on voit sur la figure 4 un passage de marche de la ligne de bit LB2 lors de sa prise de contact avec les régions de drains des transistors T12 et T22. Toutes les lignes de bit, réalisées par exemple en aluminium, vont être soumises à des passages de marche toutes les deux rangées de transistors, ce qui constitue un risque important de cassure des lignes d'aluminium.

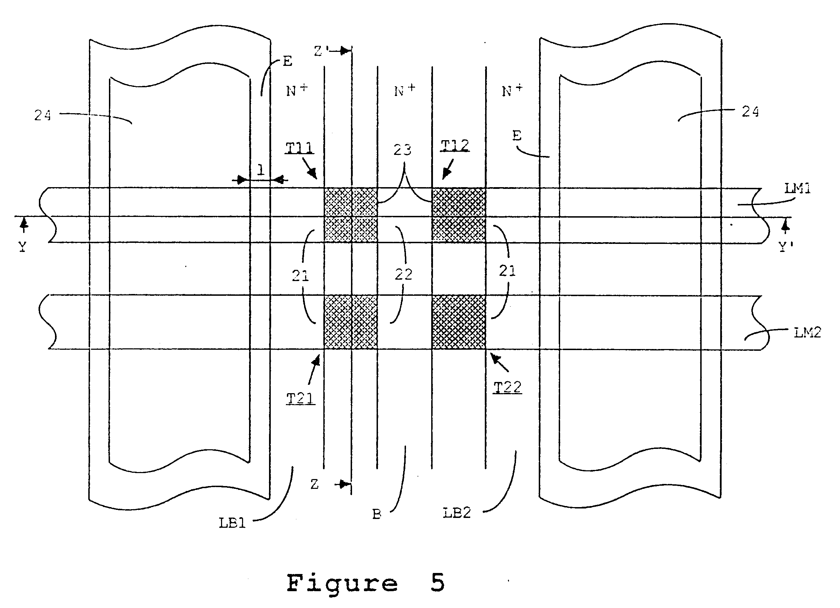

La présente invention propose une architecture représentée à la figure 5 qui évite ces inconvénients.

Dans l'architecture de la figure 5, les transistors sont toujours disposés en réseau de rangées et colonnes, les transistors de la première rangée étant encore désignés par T11 et T12, ceux de la deuxième rangée par T21 et T22, et le transistor Tij désignant plus généralement le transistor qui est au carrefour de la rangée i et de la colonne j.

Les grilles de commande des transistors de la rangée i sont encore toutes reliées à un conducteur de direction générale horizontale appelé ligne de mot LMi. Les lignes de mot sont encore des conducteurs (en pratique en silicium polycristallin) s'étendant selon une direction horizontale (direction des rangées).

Les lignes de bit LBj sont constituées de régions du substrat d'un premier type de conductivité, par exemple $N^+$. Chaque ligne de bit fait directement office de drain 21 à l'emplacement de chaque transistor. Il n'y a donc plus besoin de prévoir un contact toutes les deux rangées de transistors sur chacune des lignes de bit (contacts désignés par 11 sur la figure 2).

Des lignes à potentiel constant, conductrices, de direction générale verticale, sont intercalées une fois sur deux entre deux lignes de bit, elles sont désignées par B. Ces lignes à potentiel constant B sont constituées par des régions du premier type de conductivité, comme les lignes de bit LBj, et elles font office de sources 22 aux emplacements des transistors.

Les grilles flottantes 23 des transistors sont réalisées par un premier niveau de silicium polycristallin (poly 1) et situées de chaque côté de chaque ligne à potentiel constant B.

Les grilles de commande des transistors se superposent aux grilles flottantes, avec entre elles la couche d'oxyde interpoly, et elles sont formées par une partie des lignes de mot qui sont elles-mêmes réalisées par un deuxième niveau de silicium polycristallin (poly 2).

Puisque la source et le drain d'un transistor sont disposés selon une direction horizontale, le courant dans le canal circulera dans la direction horizontale, ou direction des lignes de mot, et ainsi, le transistor possèdera une région de canal orientée dans le même sens, que les lignes de mot.

De chaque côté des deux lignes de bit LB1 et LB2, situées de part et d'autre de la même ligne à potentiel constant B, se trouvent des zones d'isolement 24, qui sont en principe réalisée en oxyde de silicium épais.

Des zones E, réalisées par le premier niveau de silicium polycristallin (poly 1), recouvrent les zones d'isolement 24.

Ces zones E débordent de chaque côté des zones d'isolement, suivant la direction horizontale, d'une longueur 1. Un avantage associé à ces débordements sera exposé ci-après.

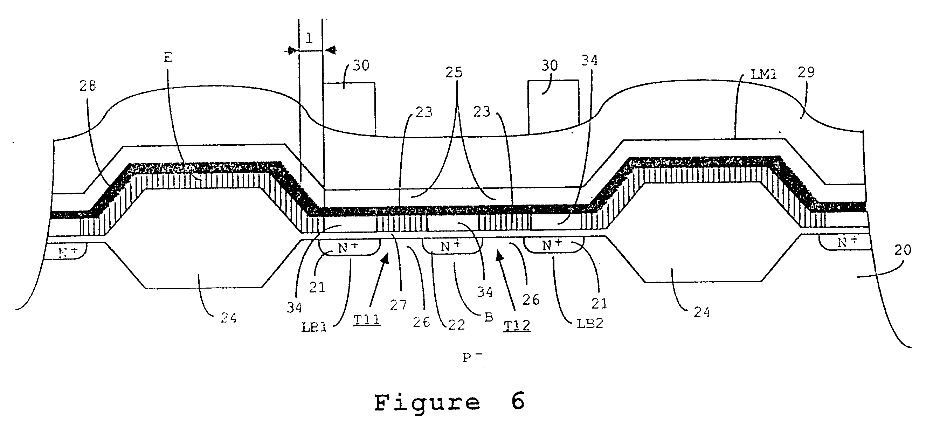

La figure 6 représente une vue en coupe suivant l'axe YY' de la figure 5 des deux transistors T11 et T12. On peut y voir :

- une ligne à potentiel constant B, constituée d'une diffusion $N^+$, qui, à l'emplacement des transistors, fait office de source 22 commune pour les deux transistors T11 et T12 ;
- une ligne de bit LB1 pour le transistor T11 et une ligne de bit LB2 pour le transistor T12, constituées de diffusions $N^+$, chacune faisant office de drain 21 à l'emplacement des transistors ;
- une ligne de mot LM1, transversale aux précédentes, réalisée par un deuxième niveau de silicium polycristallin, qui fait office de grille de commande 25 à l'emplacement des transistors ;
- deux zones d'isolement 24, disposées de part et d'autre des couples de transistors d'une même rangée dont les sources sont reliées à une même ligne à potentiel constant ;
- deux zones E, réalisées par le premier niveau de silicium polycristallin, superposées à chaque zone d'isolement 24, et qui débordent de chaque côté, suivant une direction parallèle à l'axe YY', d'une longueur 1.

Les dispositifs sont situés sur un substrat 20. Les régions de source 22 et de drain 21, d'un premier type de conductivité, par exemple $N^+$, sont séparées par une région de canal 26, d'un type de conductivité opposé, par exemple $P^-$.

Sous les grilles flottantes 23 se trouve une couche d'oxyde de grille 27, et, entre les grilles flottantes et les grilles de commande 25, on observe une couche d'oxyde interpoly 28.

Une couche d'oxyde 34 est située entre les grilles flottantes des deux transistors T11 et T12, et entre les grilles flottantes et les zones E. De façon classique, un procédé de planarisation est utilisé pour que les surfaces supérieures de cette couche 34 et du premier niveau de silicium polycristallin soient au même niveau. Cette couche 34 est par exemple constituée de tétra éthyle ortho silicate ou TEOS.

La ligne de mot LM1 est recouverte d'une couche isolante 29. Cette couche 29 est par exemple réalisée en oxyde de silicium dopé au bore et au phosphore (BPSG).

Deux lignes conductrices 30, réalisées par exemple en aluminium, sont situées sur la couche isolante 29, chacune étant placée au-dessus d'une ligne de bit. Ces lignes conductrices 30 courent tout le long de la mémoire.

Elles sont connectées à des lignes de bit d'autres blocs mémoire (en effet, les cellules mémoire sont habituellement regroupées en blocs occupant un certain nombre de rangées et de colonnes) permettant ainsi d'appliquer le potentiel désiré à ces lignes de bit et aux drains des transistors auxquels les lignes de bit sont reliées.

D'après l'architecture selon l'invention, les lignes conductrices 30 ne subissent pas de marches ou différences de niveaux abruptes sur la mémoire. C'est un avantage par rapport à l'architecture précédente, selon laquelle les lignes de bit, qui sont des lignes conductrices réalisées par exemple en aluminium, subissent des différences de niveaux abruptes lors de contacts situés toutes les deux rangées de transistors (la figure 4 illustre un tel contact).

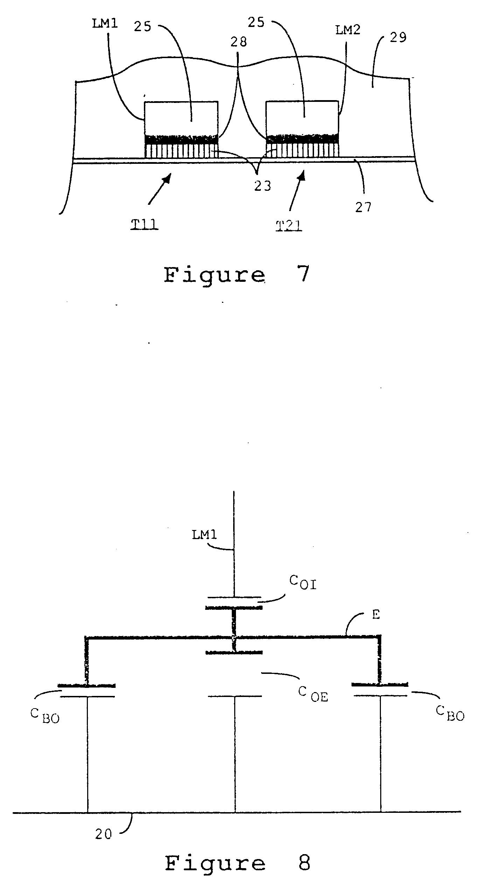

Sur la figure 7, qui représente une vue en coupe suivant l'axe ZZ' de la figure 5, on voit les grilles flottantes 23 des transistors T11 et T21, ces grilles flottantes étant situées au-dessus de la couche d'oxyde de grille 27. On observe également les deux lignes de mot LM1 et LM2, qui sont réalisées par le deuxième niveau de silicium polycristallin, et qui, à l'emplacement des transistors font office de grilles de commande 25. Entre la grille de commande et la grille flottante est située une couche d'oxyde interpoly 28. La couche isolante 29 recouvre l'ensemble.

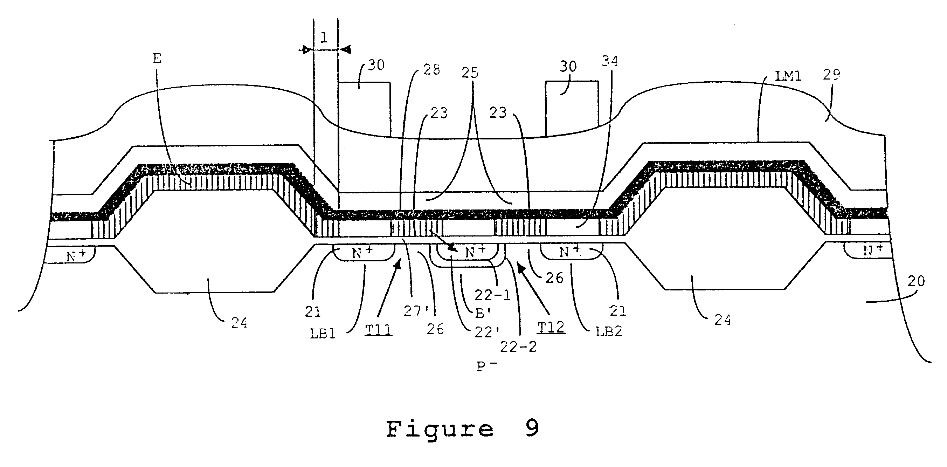

Sur la figure 8, on voit un schéma de l'agencement des capacités impliquées autour d'une zone d'isolement 24, qui est par exemple représentée sur la figure 6.

Si l'on considère cette figure 8, il apparaît une capacité $C_{OI}$ au niveau de la couche d'oxyde interpoly 28 située entre la ligne de mot LM1 et la zone E. On a aussi une capacité $C_{OE}$ au niveau de la zone d'isolement 24, qui est en principe réalisée en oxyde de silicium épais, et qui est située entre la zone E et le substrat 20. Il existe enfin une capacité $C_{BO}$ correspondant à la partie de la zone E qui déborde d'une longueur 1 de chaque côté de la zone d'isolement 24, au niveau de la partie de la couche d'oxyde de grille 27 située entre la partie de débordement et le substrat 20.

Etant donné une tension $V_M$ appliquée à la ligne de mot LM1, on obtient la tension $V_E$ sur la zone E en calculant le facteur de couplage $\gamma$ qui relie ces deux tensions par la relation :

$$V_E = \gamma V_M$$

et qui est défini par :

$$\gamma = C_{OI}/(C_{OI} + C_{OE} + 2C_{BO})$$

On peut calculer une valeur numérique représentative du facteur de couplage en utilisant des valeurs usuelles pour les dimensions des éléments concernés :

- longueur de la zone d'isolement : 1,6 micromètres
- longueur de débordement 1 : 0,4 micromètre
- épaisseur de la zone d'isolement : 500 nm

- épaisseur de la couche d'oxyde interpoly : 20 nm
- épaisseur de la couche d'oxyde de grille : 20 nm

La valeur numérique du facteur de couplage est alors égale au rapport entre les quantités (1,6 + 0,4 + 0,4)/20 et (1,6 + 0,4 + 0,4)/20 + 1,6/500 + 2 x 0,4/20.

Le facteur de couplage est alors sensiblement égal à 0,75.

Si l'on applique une tension $V_M$ de 12 volts sur la ligne de mot LM1, la tension $V_E$ sur la zone E sera :

$$V_E = 0,75 \times 12 \text{ volts}$$
$$V_E = 9 \text{ volts}$$

La zone d'isolement 24 a ainsi une tension moins importante à supporter ; l'architecture selon l'invention permet donc de prévoir une zone d'isolement de dimensions inférieures à celles de la zone d'isolement observée dans l'architecture précédente. Il en résulte un gain de place pour la mémoire.

La figure 9 représente une variante de l'invention. On retrouve sur cette figure, qui est une vue en coupe analogue à la vue représentée à la figure 6, les différents éléments constituant l'architecture selon l'invention, les principaux étant :

- une grille flottante 23, réalisée par un premier niveau de silicium polycristallin, à l'emplacement de chaque transistor ;
- deux lignes de bit LB1 et LB2, qui font office de drain 21 à l'emplacement des transistors ;
- deux zones d'isolement 24, en oxyde de silicium épais ;
- une ligne de mot LM1, réalisée par un deuxième niveau de silicium polycristallin, qui fait office de grille de commande 25 à l'emplacement des transistors ;
- une ligne à potentiel constant, qui est désignée ici par B', et qui a cependant une structure différente de celle représentée sur la figure 6.

D'après la présente variante de l'invention, la couche d'oxyde de grille, que l'on désigne sur la figure 9 par 27', est très mince par rapport aux valeurs usuelles, elle a par exemple une épaisseur de l'ordre de 10 nm.

La ligne à potentiel constant B' est constituée de deux parties dopées à un degré différent. Il existe une première partie 22-1 fortement dopée, le dopage étant par exemple $N^+$ ; cette première partie est située dans un caisson 22-2 de même type de conductivité à faible dopage, le dopage étant alors par exemple $N^-$.

La ligne à potentiel constant B' fait encore office de source 22' à l'emplacement des transistors.

Cette nouvelle disposition permet, si une tension suffisamment élevée est appliquée à la source 22', le transfert par effet tunnel de porteurs de charge, piégés lors d'une opération de programmation dans la grille flottante des transistors, de la grille flottante à la partie de la source à haut dopage. Ce transfert est rendu possible par la grande minceur de la couche d'oxyde de grille, il est représenté par la flèche sur la figure 9. La présence de la deuxième partie faiblement dopée permet d'augmenter la tension de claquage entre la source et le substrat.

Or des régions de contact entre une couche d'oxyde mince et une zone d'oxyde épais sont pourvues de défauts qui perturbent les transferts des porteurs de charge, et l'on observe de telles régions de contact dans les structures classiques de mémoires effaçables électriquement (EEPROM et flash EPROM).

L'intérêt présenté par l'architecture selon l'invention réside dans le fait que les régions d'oxyde mince où transitent les porteurs de charge ne sont jamais en contact ou à proximité d'une zone d'oxyde épais.

Il est ainsi possible de réaliser des mémoires dites "flash" de type EPROM effaçables électriquement par application d'une tension adaptée aux sources des transistors.

## Revendications

1. Mémoire, dont les points mémoires sont constitués de transistors MOS à grille flottante, composée d'un réseau de lignes de mot (LM1, LM2) s'étendant suivant une première direction, dite de rangée, reliant des grilles de commande des transistors, et des lignes de Lit (LB1, LB2) s'étendant suivant une deuxième direction, dite de colonne, reliant des drains des transistors, les lignes de mot servant à désigner une rangée de transistors déterminée et les lignes de bit permettant de transmettre une information sur l'état logique des transistors qui leur sont connectés, dans laquelle :

   une ligne à potentiel constant (B), qui s'étend selon une colonne, relie des sources desdits transistors, est constituée par une diffusion d'un premier type de conductivité, et est intercalée une fois sur deux entre deux lignes de bit, toutes les lignes à potentiel constant étant au même potentiel,

   la région de drain (21) du premier type de conductivité de chaque transistor se prolonge suivant une colonne pour former une ligne de bit,

   une zone d'isolement (24) s'étendant selon une colonne est disposée du côté de chaque ligne de bit opposé à une ligne à potentiel constant, et

caractérisée en ce qu'une zone (E) conductrice et flottante recouvre chaque zone d'isolement (24), cette zone (E) étant composée du même matériau que celui constituant les grilles flottantes (23) des transistors.

2. Mémoire selon la revendication 1, caractérisée en ce que les transistors d'un groupe appartenant à deux rangées adjacentes et deux colonnes de part et d'autre d'une même ligne à potentiel constant sont agencés de la manière suivante :
- chaque transistor comporte une grille flottante (23) essentiellement constituée par un rectangle conducteur situé au dessus d'une zone d'un second type de conductivité constituant le canal (26) du transistor ;
- les canaux (26) de deux transistors adjacents d'une même colonne sont séparés par une région de même type de conductivité que les canaux ;
- les canaux de deux transistors d'une même rangée, les deux transistors étant situés de part et d'autre d'une même ligne à potentiel constant, sont adjacents à une même région (22) de type de conductivité opposé qui les sépare et qui sert de source aux deux transistors ; les canaux des deux transistors sont, chacun à leur extrémité opposée à celle adjacente à la région servant de source, adjacents à une région (21) de type de conductivité opposé qui sert de drain à chacun des deux transistors.

3. Mémoire selon la revendication 1, caractérisée en ce que la zone (E) recouvrant la zone d'isolement (24), ainsi que les grilles flottantes (23), sont constituées de silicium polycristallin.

4. Mémoire selon la revendication 1, caractérisée en ce que la zone (E) recouvrant la zone d'isolement (24) déborde, suivant la direction parallèle aux lignes de mot, de chaque côté de la zone d'isolement d'une longueur choisie (l).

5. Mémoire selon la revendication 1, caractérisée en ce que les zones (E) recouvrant les zones d'isolement (24) et les grilles flottantes (23) sont disposées à espacement constant suivant la direction des rangées.

6. Mémoire selon la revendication 1, caractérisée en ce que, dans les transistors des cellules, une couche de dioxyde de silicium (27') d'une épaisseur inférieure à 20 nm sépare le canal (26) et la grille flottante (23) (figure 9), et en ce que la région (22') servant de source est constituée d'une partie (22-1) à haut dopage située dans un caisson (22-2) du même type de conductivité à faible dopage, d'où il résulte que des électrons peuvent transiter à travers la couche de dioxyde de silicium par effet tunnel de la grille flottante à la partie de la source à haut dopage sous l'application d'une tension adaptée à la source, ce qui donne à la mémoire la capacité d'être effacée électriquement par application d'une tension adaptée aux sources des transistors.

## Claims

1. A memory, the memory points of which are constituted by floating gate MOS transistors, comprising a word line array (LM1, LM2) extending along a first direction, called row direction, connecting the transistor control gates, and bit lines (LB1, LB2) extending along a second direction, called column direction, interconnecting the transistor drains, said word lines addressing a determined transistor row and said bit lines permitting to transmit an information about the logical state of the connected transistors, wherein:

a constant-potential line (B), extending along a column, connects the transistor sources, is constituted by a diffusion of a first conductivity type, and is arranged between each pair of bit lines, all the constant-potential lines being at the same potential,

the drain region (21) of the first conductivity type of each transistor extends along a column to form a bit line,

an isolation area (24) extending along a column is arranged on the side of each bit line opposed to a constant-potential line, and

characterized in that a conductive and floating area (E) covers said isolation area (24), said conductive area (E) being constituted by the same material as the one constituting the floating gates (23) of the transistors.

2. A memory according to claim 1, characterized in that the transistors of a group belonging to two adjacent rows and to two columns on each side of a same constant-potential line are arranged in the following way:
- each transistor comprises a floating gate (23) mainly constituted by a conductive rectangle arranged over a second conductivity type area constituting the channel (26) of said transistor;
- the channels (26) of two adjacent transistors of a same column are separated by a region of the same conductivity type as the channels; and

- the channels of two transistors of a same row, the two transistors being arranged on both sides of a given constant-potential line, are adjacent to a same region (22) of the opposite conductivity type which separates said transistors and which constitutes the source of the two transistors; the channels of said two transistors are, at their end opposite to the region corresponding to the source, adjacent to a region (21) of the opposite conductivity type which corresponds to the drain of each of said two transistors.

3. A memory according to claim 1, characterized in that the conductive area (E) covering said isolation area (24), together with the floating gates (23), are made of polycrystalline silicon.

4. A memory according to claim 1, characterized in that said conductive area (E) covering said isolation area (24) projects, according to a direction parallel to the word lines, on each side of the isolation region according to a predetermined length (l).

5. A memory according to claim 1, characterized in that each of said conductive areas (E) covering said isolation areas (24) and the floating gates (23) are arranged at a constant pitch according to the row direction.

6. A memory according to claim 1, characterized in that, in each transistor, a silicon dioxide layer (27') having a thickness lower than 20 nm separates the channel (26) from the floating gate (23) (Fig. 9), and wherein the region (22') corresponding to the sources is made of a highly doped section (22-1) arranged in a pocket (22-2) having the same conductivity type and a low doping level, whereby electrons may tunnel through the silicon dioxide layer from the floating gates to the highly doped source region further to the application of a selected voltage to the source, and whereby the memory is electrically erasable.

**Patentansprüche**

1. Speicher, dessen Speicherpunkte aus MOS-Transistoren mit schwimmendem Gate bestehen, welcher ein Netz von Wortlinien (LM1, LM2), die sich in einer ersten Richtung, der sogenannten Zeilenrichtung, erstrecken und die Steuergates der Transistoren verbinden, und Bit-Linien (LB1, LB2) umfaßt, die sich in einer zweiten, der sogenannten Spaltenrichtung, erstrecken und die Drains der Transistoren verbinden, wobei die Wortlinien dazu dienen, eine bestimmte Reihe von Transistoren zu spezifizieren und die Bit-Linien es gestatten, eine Information über den logischen Zustand der Transistoren, mit denen sie verbunden sind, zu übermitteln, bei dem

- eine Linie mit konstantem Potential (B), die sich entlang einer Spalte erstreckt, die Sources der Transistoren verbindet, aus einer Diffusion eines ersten Leitungstyps besteht und jedes zweite Mal zwischen zwei Bit-Linien eingefügt ist, wobei alle Linien mit konstantem Potential auf demselben Potential liegen,
- der Drain-Bereich (21) vom ersten Leitungstyp jedes Transistors sich in der Richtung einer Spalte erstreckt, um eine Bit-Linie zu bilden,
- ein Isolationsbereich (24) sich entlang einer Spalte erstreckt und auf der Seite jeder Bit-Linie angeordnet ist, die einer Linie mit konstantem Potential gegenüberliegt, und

der dadurch gekennzeichnet ist,
daß ein leitender und schwimmender Bereich (E) jeden Isolationsbereich (24) überdeckt, wobei dieser Bereich (E) aus dem gleichen Material besteht wie dem, das die schwimmenden Gates (23) der Transistoren bildet.

2. Speicher nach Anspruch 1, dadurch gekennzeichnet, daß die Transistoren einer Gruppe, die zu zwei benachbarten Zeilen und zwei Spalten gehören, die zu beiden Seiten derselben Linie mit konstantem Potential liegen, in der folgenden Weise aufgebaut sind:

- jeder Transistor umfaßt ein schwimmendes Gate (23), das im wesentlichen aus einem rechteckigen Leiter besteht, der sich oberhalb eines Bereichs vom zweiten Leitungstyp befindet, der den Kanal (26) des Transistors bildet,
- die Kanäle (26) von zwei benachbarten Transistoren in derselben Spalte sind durch ein Gebiet vom selben Leitungstyp wie dem der Kanäle getrennt,
- die Kanäle von zwei Transistoren in derselben Zeile, die zu beiden Seiten einer und derselben Linie mit konstantem Potential angeordnet sind, sind einem und demselben Bereich (22) vom entgegengesetzten Leitungstyp benachbart, der sie trennt und als Source für die zwei Transistoren dient, und die Kanäle der zwei Transistoren sind jeweils an dem entgegengesetzten Ende zu dem, das dem als Source dienenden Gebiet benachbart ist, einem Bereich (21) vom entgegengesetzten Leitungstyp benachbart, der für jeden der beiden Transistoren als Drain dient.

3. Speicher nach Anspruch 1, dadurch gekennzeichnet, daß der Bereich (E), der den Isolationsbereich (24) überdeckt, ebenso wie die schwimmenden Gates (23) aus polykristallinem Silicium besteht.

4. Speicher nach Anspruch 1, dadurch gekennzeichnet, daß der Bereich (E), der den Isolationsbereich (24) überdeckt, in der Richtung parallel zu den Wortlinien auf jeder Seite des Isolationsbereichs um eine gewählte Länge (l) vorsteht.

5. Speicher nach Anspruch 1, dadurch gekennzeichnet, daß die Bereiche (E), welche die Isolationsbereiche (24) bedecken, und die schwimmenden Gates (23) mit konstantem Abstand in der Richtung der Zeilen angeordnet sind.

6. Speicher nach Anspruch 1, dadurch gekennzeichnet, daß bei den Zellentransistoren eine Siliciumdioxidschicht (27') mit einer Dicke von weniger als 20nm den Kanal (26) und das schwimmende Gate (23) (Fig. 9) trennt und daß der als Source dienende Bereich (22') aus einem Teil mit hoher Dotierung (22-1) besteht, der sich innerhalb eines Kastens (22-2) vom selben Leitungstyp mit schwacher Dotierung befindet, woraus sich ergibt, daß die Elektronen durch die Siliciumdioxidschicht über den Tunneleffekt von dem schwimmenden Gate zu dem Teil der Source mit hoher Dotierung bei Anlegen einer an die Source angepaßten Spannung wandern können, was dem Speicher die Fähigkeit verleiht, elektrisch durch das Anlegen einer an die Sources der Transistoren angepaßten Spannung gelöscht zu werden.

Figure 1A

Figure 1B

Figure 2

Figure 3

Figure 4

Figure 5

Figure 6

Figure 7

Figure 8

16

Figure 9

EP 0 356 346 B1